Europäisches Patentamt

(19) European Patent Office

Office européen des brevets

(11) Publication number: **0 049 326**

**A1**

(12) **EUROPEAN PATENT APPLICATION**

(21) Application number: **81104816.4**

(22) Date of filing: **22.06.81**

(51) Int. Cl.³: **G 11 C 11/24**

(30) Priority: **03.10.80 US 193782**

(43) Date of publication of application:
**14.04.82 Bulletin 82/15**

(84) Designated Contracting States:
**DE FR GB**

(71) Applicant: **Rockwell International Corporation**
**2230 East Imperial Highway**
**El Segundo, California 90245(US)**

(72) Inventor: **Sclar, Nathan (NMI)**
**23634 Decorah Road**
**Diamond Bar California(US)**

(74) Representative: **Wagner, Karl H., Dipl.-Ing.**
**P.O. Box 22 02 46 Gewuerzmuehlstrasse 5**
**D-8000 München 22(DE)**

(54) **Semi-conductor memory device for digital and analog memory application using single MOSFET memory cells.**

(57) The invention comprises a method and apparatus for placing a charge on the gate electrode of a MOSFET fabricated in a selected semiconductor material to serve as a memory, either of digital significance or analog significance depending upon the magnitude of the charge stored. An access MOSFET provides a path for the charge to reach the memory MOSFET gate electrode in the write mode. The same path is utilized for eliminating the charge in the erase mode with the current flow in the opposite direction. An access potential may be applied to the gate of the access MOSFET to permit its channel to become conducting for the above two modes. Non destructable readout is available by applying a predetermined voltage to the source electrode of the memory MOSFET and measuring the current flow through the memory MOSFET at either the source or drain side of the channel for a determination of charge or no charge or towards magnitude.

The invention herein described was made in the course of or under a contract or subcontract thereunder, (or grant) with the Department of the Army.

EP 0 049 326 A1

Croydon Printing Company Ltd

A NON VOLATILE STATIC ONE MEMORY ELEMENT
RAM DEVICE WITH NO STANDBY POWER REQUIREMENTS
FOR DIGITAL AND ANALOG MEMORY APPLICATION AND METHOD

Field of the Invention

The invention relates to the method and apparatus for constructing a RAM memory device in a semiconductor utilizing an electric charge applied to the gate electrode of a memory MOSFET and isolated there to serve as a digital or analog memory.

Background Art

The closest known prior art is the conventional six MOSFET (flip-flop) static RAM cell as described in the Intel Corp. "The Semiconductor Book" published by Wiley-Interscience 1978. This cell requires continuous standby electrical power to provide storage.

Brief Description of the Invention

The invention comprises the method of using a MOSFET as a single memory element RAM cell wherein an electrical charge is placed on the gate electrode of the MOSFET and the charge is isolated to serve as a memory. The apparatus utilizes the memory MOSFET gate and means for charging the gate and isolating the charge on the gate.

Brief Description of the Drawings

FIGURE 1 is a curcuit diagram of the preferred arrangement of the memory MOSFET and the access MOSFET, and

FIGURE 2 is a memory organization chart for a RAM using the subject RAM device

Description of a Preferred Embodiment of the Invention

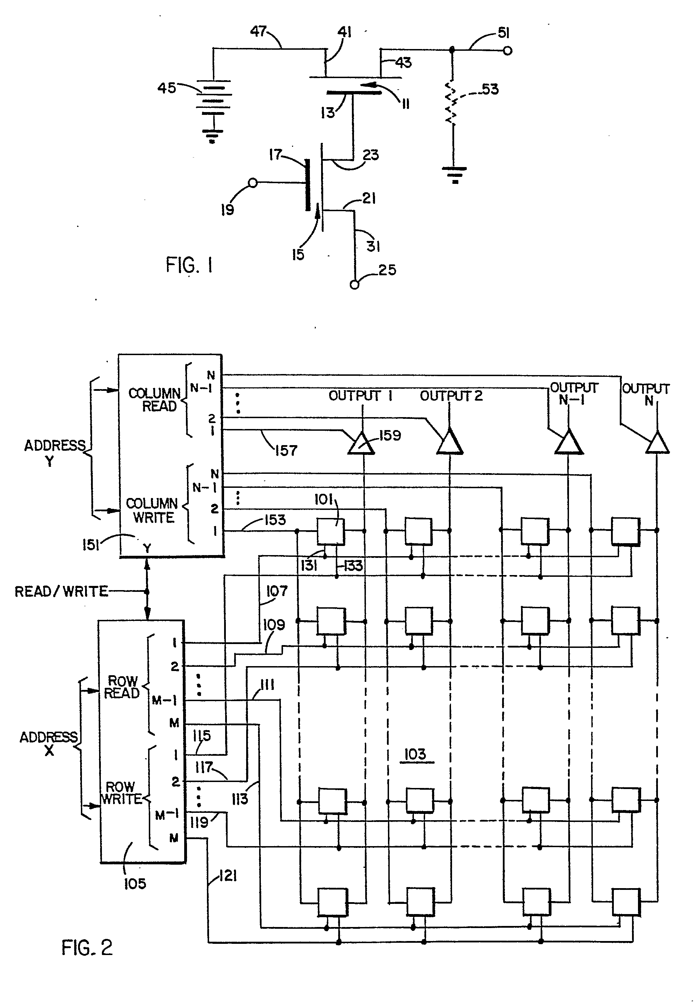

In FIG. 1 MOSFET 11 is the memory element and its gate 13 will receive the charge and hold the same as memory storage.

MOSFET 15 is the access element for memory MOSFET 11. Its gate 17 is configured to receive access control voltage eg 5 volts on terminal 19 whenever it is desired to close a conductive path or channel between source electrode 21 and drain electrode 23, this source electrode being connected to terminal 25 for purposes of providing the signal write mode and the signal erase mode.

When a signal charge is to be stored on gate 13, a signal pulse is applied to input terminal 25 and the access control voltage is applied to gate terminal 19. The signal charge passes along lead 31, source electrode 21 of access MOSFET 15, along its now conductive channel to drain electrode 23 and then to gate 13 of memory MOSFET 11.

When the signal is removed and the access control potential removed, the charge is trapped on gate electrode 13 because the charge actually biases the junction innerface of drain 23 in access MOSFET 17 in the opposite direction which prevents the charge from leaking off or decaying within certain limits to be discussed.

The same signal write mode path may be used to erase the signal in the erase mode. It is only necessary to connect terminal 25 to a charge sink or to a voltage source having a polarity opposite to the charge.

The non-destructive readout feature of the invention resides in developing a current between the source electrode 41 and the drain electrode 43 of memory MOSFET 11 which is related to the amount of charge on gate 13. This is accomplished by connecting a voltage from source 45 to lead 47 connected to source electrode 41 of memory MOSFET 11. The voltage source 45 may be of a predetermined amount of readout voltage between 5 and 10 volts. The current developed through the channel of MOSFET 11 between source 41 and drain 43 may be measured by an ameter in lead 51 or may be measured by a voltmeter connected across resistor 53 but in either event the current will depend upon the impedance of the memory element channel of MOSFET 11 which in turn is related to the magnitude of the voltage charge stored on its gate electrode 13. In this manner a measure of the magnitude of the current will provide an analog output whereas a measure of the presence or absence of current due to the presence or absence of charge may be used to provide a digital output.

With the foregoing in mind the purposes and advantages of the invention may be better appreciated. In one application, a need existed for static RAM devices to upgrade the performance on the focal plane of multi-element infrared detector arrays which operate at low temperatures. The power dissipation associated with conventional static RAMs which can aggregate hundreds of milliwatts per chip, severely restricts their application in this environment. Using the low temperature properties of semiconductors, a new RAM device concept is herein disclosed utilizing the single component memory device 11 for simple nondestructive readout. The addition of access MOSFET 15 permits the write/erase function to be added by this single additional non-memory element, the two MOSFETs comprising a RAM cell.

The memory element 11 employed may be either a conventional n or p channel MOSFET, and the complementary access element 15 is a similar MOSFET. In this preferred embodiment the enhancement mode of operation is utilized and requires no standby power, although the depletion mode may be also employed.

During operation, the deposited charge on gate 13 is isolated from the substrate by the insulator oxide of the memory element 11 and by the opposed junction of the drain of the access MOSFET. At the low temperature of operation, the latter path is effectively blocked so that the charge remains fixed on the gate of the memory device for extended times. Retention times of at least 17 hours have been verified at liquid helium temperatures with no indication of charge loss. It may thus be seen that in the suggested application by way of example, a first infrared picture of the target area could be stored in a RAM memory comprised of the described type cells. A subsequent scene could be compared to the prior scene and the movement areas immediately detected. Hence then, for such an application, storage of a minute or so may be adequate.

The operating temperature of the memory device is controlled by the insulating character of the back biased junction drain contact with respect to the substrate. The highest operational temperature is determined by the amount of charge leakage that can be tolerated within a given time measurement increment. The measurement of charge with no diminution in stored charge was obtained on a device constructed using silicon. It took place at approximately 5° Kelvin. Spot checks at 77° Kelvin indicated a similar performance. The operating temperature limit for silicon for useful retention times is expected to be in the 100° Kelvin range. However to reach higher operating temperatures, the choice of the semiconductor material also becomes a factor, i.e. gallium arsenide will raise the operational temperature by a factor of approximately 1.4, gallium phosphide by a factor of approximately 2.4, whereas silicon carbide will raise the operational temperature by a factor of approximately 2.9. Thus operation at room temperature may be had for sufficient periods of time by utilizing an optimum semiconductor material. The determination of optimum material is made by selecting the deeper energy gap semiconductor material. For example, in silicon at 77°K, the energy gap between the valence and the conductor electrons is approximately 1.0 electron volts. Whereas in silicon carbide this gap deepens at room temperature to approximately 2.9 electron volts.

Of course the MOSFETs may be produced utilizing VLSI techniques to be of minimum size while providing a high density MOS RAM at low cost utilizing simple processing. With the choice of n-channel MOSFETs, high speed access times competitive with RAM state of the art can be obtained. The higher channel mobility at lower temperatures contributes to even higher speeds than is presently available while avoiding the requirement for standby power.

In FIG. 2 a typical memory organization for a RAM memory is shown utilizing the circuitry of FIG.1. Each of the square boxes 101 comprises the circuitry of FIG. 1, i.e. including the memory MOSFET and the access MOSFET with the number 103 indicating the entire RAM.

The access control voltage is provided for the x-access lines and thus control box 105 may be selectively addressed to apply the access control potential to the row read columns shown as lines 107, 109, etc. to the m-1 line designated at 111 and the m line at 113. Similarly the row write lines are shown as lines 1 and 2 at 115 and 117, etc. to line m-1 at 119 and the m line at 121. Thus, the read row line 107 leads to input terminal 131 of cell 101 whereas the write row lead 115 extends to terminal 133. In this way either reading or writing may be accomplished at cell 101 provided that the corresponding y lead from control box 151 is also energized. This would comprise y lead 153 for column write or cell 101. The column read line is designated at 157 connected to output 1 via box 159 which may comprise a load resistor, buffer, or amplifier for readout. The remaining circuitry operates in the same manner simply by addressing boxes 105 and 151 to activate a given cell.

In summary the advantages of the invention are that the memory is non volatile or static and needs no replenishment, the cells may operate as a random access memory not just a rom, no standby power is required and the memory may store digital or analog values, the memory itself is a single element and the readout is non-destructive. However, it should be remembered that the drain junction and the access MOSFET must be of high quality and the higher quality leads to longer storage just as the proper selection of semiconductor material and the usage of lower temperatures.

The invention may be summarized as follows:

1.  The method of using a MOSFET as a single element RAM cell comprising the steps of:

        placing an electrical charge on the gate electrode of said MOSFET; and,

        isolating said charge.

2.  The method of item 1 wherein:

        said isolating is achieved by connecting the gate electrode to a drain electrode of a further MOSFET, whereby control of said further MOSFET determines said isolation.

3.  The method of item 2 wherein:

        access to the gate of said first mentioned MOSFET is available by way of the drain electrode, conducting channel and source, of said further MOSFET.

4.  The method of item 3 wherein:

        storing said charge is accomplished by turning on said further MOSFET by applying voltage to its gate electrode.

5.  The method of item 4 wherein:

        erase is accomplished by applying a voltage having a polarity opposite to said charge to the source electrode of said further MOSFET whereby said charge leaves the gate electrode via the drain electrode, conducting channel and the source electrode of said further MOSFET.

6.  The method of item 4 wherein:

        erase is accomplished by connecting the source electrode of said further MOSFET to a charge sink whereby the stored charge is caused to leave said gate electrode via the drain electrode, conducting channel and source electrode of said further MOSFET.

7.  The method of item 3 wherein:

        readout is accomplished by applying a voltage to the source electrode of said MOSFET; and, sensing for current flow through said MOSFET.

8. The method of item 7 wherein:
   said charge is substantially static;
   said charge requires no standby power;
   said charge may provide analog or digital output; and,
   readout of said charge is non-destructive.

9. The method of item 4 wherein:
   the storage time for said charge is extendible by selecting a
semiconductor material of higher energy gap.

10. The method of item 9 wherein:
    the storage time for said charge is extendible by improving
the insulating quality of the drain junction of said further MOSFET.

11. The method of item 10 wherein:
    the storage time for said charge is extendible by reducing the
operating temperature of said further MOSFET.

12. A single memory element RAM cell comprising, in combination:
    a MOSFET having a gate; and,
    means for charging said gate and isolating the charge on the
gate.

13. The cell of item 12 wherein:
    said means comprises a further MOSFET.

14. The cell of item 13 wherein:
    said gate electrode is connected to a drain electrode of
said further MOSFET, whereby control of said further MOSFET determines
said isolation.

15. The cell of item 14 further comprising:
    an access path to said gate including the drain electrode, conducting channel, and source of said further MOSFET.

16. The cell of item 15 comprising:

means for applying voltage to the source electrode of said first mentioned MOSFET for developing current flow through said first mentioned MOSFET, the magnitude of which is indicative of the amount of stored charge.

17. A non-volatile static RAM cell with no standby power requirements for digital and analog memory applications, comprising in combination:

a memory element MOSFET having a source, drain and gate;

an access element MOSFET for applying a charge to said gate and for isolating said charge as a memory condition;

said access MOSFET having a source, drain and gate;

a connection between the gate of the memory MOSFET and the drain of the access MOSFET;

means for applying access control voltage to the gate of said access MOSFET to write into said RAM cell by applying charge to the gate of said memory MOSFET via the source, conducting channel, and drain of said access MOSFET; and,

means for applying a predetermined voltage to the source of said memory MOSFET for inducing current flow in the memory MOSFET indicative of the charge magnitude on said gate of the memory MOSFET.

What is claimed is:

1. The method of using a MOSFET as a single element RAM cell comprising the steps of:

placing an electrical charge on the gate electrode of said MOSFET; and,

isolating said charge.

2. The method of Claim 1 wherein:

said isolating is achieved by connecting the gate electrode to a drain electrode of a further MOSFET, whereby control of said further MOSFET determines said isolation.

3. The method of Claim 2 wherein:

access to the gate of said first mentioned MOSFET is available by way of the drain electrode, conducting channel and source, of said further MOSFET.

4. The method of Claim 3 wherein:

storing said charge is accomplished by turning on said further MOSFET by applying voltage to its gate electrode.

5. The method of Claim 4 wherein:

erase is accomplished by applying a voltage having a polarity opposite to said charge to the source electrode of said further MOSFET whereby said charge leaves the gate electrode via the drain electrode, conducting channel and the source electrode of said further MOSFET.

6. The method of Claim 4 wherein:

erase is accomplished by connecting the source electrode of said further MOSFET to a charge sink whereby the stored charge is caused to leave said gate electrode via the drain electrode, conducting channel and source electrode of said further MOSFET.

7. The method of Claim 3 wherein:

readout is accomplished by applying a voltage to the source electrode of said MOSFET; and, sensing for current flow through said MOSFET.

8. The method of Claim 7 wherein:

said charge is substantially static;

said charge requires no standby power;

said charge may provide analog or digital output; and,

readout of said charge is non-destructive.


9. The method of Claim 4 wherein:

the storage time for said charge is extendible by selecting a semiconductor material of higher energy gap.


10. The method of Claim 9 wherein:

the storage time for said charge is extendible by improving the insulating quality of the drain junction of said further MOSFET.


11. The method of Claim 10 wherein:

the storage time for said charge is extendible by reducing the operating temperature of said further MOSFET.


12. A single memory element RAM cell comprising, in combination:

a MOSFET having a gate; and,

means for charging said gate and isolating the charge on the gate.


13. The cell of Claim 12 wherein:

said means comprises a further MOSFET.


14. The cell of Claim 13 wherein:

said gate electrode is connected to a drain electrode of said further MOSFET, whereby control of said further MOSFET determines said isolation.


15. The cell of Claim 14 further comprising:

an access path to said gate including the drain electrode, conducting channel, and source of said further MOSFET.

16. The cell of Claim 15 comprising:

means for applying voltage to the source electrode of said first mentioned MOSFET for developing current flow through said first mentioned MOSFET, the magnitude of which is indicative of the amount of stored charge.


17. A non-volatile static RAM cell with no standby power requirements for digital and analog memory applications, comprising in combination:

a memory element MOSFET having a source, drain and gate;

an access element MOSFET for applying a charge to said gate and for isolating said charge as a memory condition;

said access MOSFET having a source, drain and gate;

a connection between the gate of the memory MOSFET and the drain of the access MOSFET;

means for applying access control voltage to the gate of said access MOSFET to write into said RAM cell by applying charge to the gate of said memory MOSFET via the source, conducting channel, and drain of said access MOSFET; and,

means for applying a predetermined voltage to the source of said memory MOSFET for inducing current flow in the memory MOSFET indicative of the charge magnitude on said gate of the memory MOSFET.

FIG. 1

FIG. 2

0049326

European Patent
Office

**EUROPEAN SEARCH REPORT**

Application number

EP 81 10 4816

| | DOCUMENTS CONSIDERED TO BE RELEVANT | | CLASSIFICATION OF THE APPLICATION (Int. Cl. 3) |
|---|---|---|---|
| Category | Citation of document with indication, where appropriate, of relevant passages | Relevant to claim | |
| X | NEC RESEARCH & DEVELOPMENT, no. 12, October 1968, pages 29-36 Tokyo, JP. O. ENOMOTO et al.: "Most capacitor memory" <br><br> * Page 30, column 1, line 14 - page 30, column 2, line 10; page 32, column 1, lines 9-12; page 35, column 1, lines 1-5; figures 1,2 * <br><br>-- | 1-8, 12-17 | G 11 C 11/24 |
| X | US - A - 3 599 180 (PAIVINEN et al.) <br><br> * Column 2, lines 25-35; column 10, lines 18-38; column 10, line 55 - column 11, line 3; figure 4 * <br><br>-- | 1-8, 11-17 | **TECHNICAL FIELDS SEARCHED (Int.Cl. 3)** <br><br> G 11 C 11/24 <br> H 01 L 27/14 |
| X | US - A - 3 742 465 (REGITZ) <br><br> * Column 3, lines 12-36; column 3, line 47 - column 5, line 13; column 5, line 41 - column 6, line 1; figure 1 * <br><br>-- | 1-8, 10, 12-17 | |
| | IEEE TRANSACTIONS ON ELECTRON DEVICES, vol. ED-26, no. 12, December 1979, pages 1970-1977 New York, U.S.A. JUN-ICHI NISHIZAWA et al.: "Static induction transistor image sensors" <br><br> * Page 1971, column 1, last paragraph - page 1972, column 1, line 14; figure 5 * <br><br>---- | 9, 11 | **CATEGORY OF CITED DOCUMENTS** <br><br> X: particularly relevant if taken alone <br> Y: particularly relevant if combined with another document of the same category <br> A: technological background <br> O: non-written disclosure <br> P: intermediate document <br> T: theory or principle underlying the invention <br> E: earlier patent document, but published on, or after the filing date <br> D: document cited in the application <br> L: document cited for other reasons <br><br> &: member of the same patent family, corresponding document |

| | The present search report has been drawn up for all claims | | |
|---|---|---|---|
| Place of search <br> The Hague | Date of completion of the search <br> 19-01-1982 | Examiner <br> HARMS | |

EPO Form 1503.1 06.78